# EUROPEAN PATENT APPLICATION

(11) **EP 2 295 883 A2**
(43) Date of publication of application: **16.03.2011**
(21) Application number: 10251304.1
(22) Date of filing: 22.07.2010
(51) Int. Cl.: F24F 13/15

(54) **Back draft damper**

(30) Priority: 29.07.2009 US 462172; 06.05.2010 US 775000
(71) Applicant: Huntair, Inc, Tualatin, OR 97062 (US)
(72) Inventor: Hopkins, Larry, Happy Valley Oregon 97015 (US); Jones, Emily, Tualatin Oregon 97062 (US); Passadore, Albert, Beaverton Oregon 97007 (US); Benson, David, West Linn Oregon 97068 (US)
(74) Representative: Bhimani, Alan

(57) **Abstract**

A damper is provided. The damper includes a frame (10) having a central opening (12) through which air passes. A plurality of vanes (22) are rotatably mounted within the frame (10). At least one of the vanes (22) is oriented about a rotational axis that is offset at a non-orthogonal angle with respect to one of a horizontal and vertical axis.

## Description

### BACKGROUND OF THE INVENTION

Large air handling systems often require back draft dampers to be placed at select locations to prevent air from flowing in the direction opposite normal air flow when the fan that is creating the airflow is not operating. This is particularly true with multi-fan systems. With multi-fan systems it is common to shut off one or more of the fans to allow the remaining fans to run at a predetermined select performance level, such as a desired level of efficiency. When this occurs some air from the operating fans will flow back through the non-operating fans if the non-operating fans do not have back draft dampers.

There basically are three types of back draft dampers: manual systems where a blank off plate or damper is deployed to prevent reverse airflow; remotely actuated dampers where actuators are used to close a damper; and gravity actuated dampers where the damper is opened by the pressure of air passing through it and is closed by the force of gravity acting on its vanes. The prior art gravity actuated dampers typically comprise several stacked side-by-side vanes which are mounted in a frame and rotate about horizontal axes. The rotational axes are typically near the leading edge of the vanes to maximize the effect of gravity on the vanes so that gravity causes the vanes to be fully closed when there is no positive airflow past the vanes. However, one disadvantage is that it takes a considerable amount of airflow to fully open the vanes and if the airflow is to low to fully open the vanes, the vanes will create excess drag and overall efficiency of the system is reduced. While the gravity effect on damper vanes that rotate about horizontal axes can be reduced by counter weighting the vanes in some manner, counter weights add to the cost and in many situations the counter weighting may need to be customized.

A need remains for an improved back draft damper.

### SUMMARY OF THE INVENTION

In one embodiment, a damper is provided. The damper includes a frame having a central opening through which air passes. A plurality of vanes are rotatably mounted within the frame. At least one of the vanes is oriented about a rotational axis that is offset at a non-orthogonal angle with respect to one of a horizontal and vertical axis.

In another embodiment, a method of installing a damper is provided. The damper includes a frame. The method includes rotatably mounting a plurality of vanes within the frame. At least one of the vanes is oriented about a rotational axis that is offset at a non-orthogonal angle with respect to one of a horizontal and vertical axis.

In another embodiment, a damper is provided having a frame having a central opening through which air passes. A plurality of vanes are rotatably mounted within the frame. The vanes having a leading edge and a trailing edge. The leading edge includes a rotational member and the trailing edge comprising a cutout having a shape that corresponds with the shape of the rotational member to nest with the rotational member of an adjacent vane when the vanes are in a closed position.

### BRIEF DESCRIPTION OF THE DRAWINGS

Figure 1 is a schematic of an air handling system in accordance with an embodiment.

Figure 2 illustrates an air processing system that may be used with the air handling system shown in Figure 1.

Figure 3 illustrates a top view of an air handling section that may be used with the air processing system shown in Figure 2.

Figure 4 is a perspective view of a damper in accordance with an embodiment.

Figure 5 is a cross sectional view taken on the line 2-2 of Figure 1.

Figure 6 is a cross sectional view taken on the line 3-3 of Figure 1.

Figure 7 is a cross sectional view of a damper vane in accordance with an embodiment.

Figure 8 is a front elevation view of a damper in accordance with an embodiment.

Figure 9 is a detailed view of a damper in accordance with an embodiment.

Figure 10 is a side elevation view of a damper in accordance with an embodiment.

Figure 11 is a front elevation view of the damper shown in Figure 10.

Figure 12 is a front elevation view of a damper in accordance with an embodiment.

Figure 13 is a perspective view of a damper in accordance with an embodiment.

Figure 14 illustrates a damper in accordance with an embodiment.

Figure 15 illustrates a damper in accordance with an embodiment.

Figure 16 illustrates a damper in accordance with an embodiment.

Figure 17 illustrates a damper in accordance with an embodiment.

Figure 18 illustrates a damper in accordance with an embodiment.

Figure 19 illustrates a damper in accordance with an embodiment.

Figure 20 illustrates a damper in accordance with an embodiment.

Figure 21 illustrates the damper shown in Figure 20 having vanes in an open configuration.

Figure 22 illustrates a damper vane in accordance with an embodiment.

Figure 23 illustrates a damper vane in accordance with an embodiment.

Figure 24 illustrates a damper in accordance with an embodiment.

Figure 25 illustrates a damper in accordance with an embodiment.

Figure 26 illustrates a damper in accordance with an embodiment.

Figure 27 illustrates a cross-sectional view of the frame shown in Figure 26.

Figure 28 illustrates a top view of the vane shown in Figure 26.

Figure 29 illustrates a side cross-sectional view of the damper shown in Figure 26.

Figure 30 is an expanded view of the vane coupled to the frame, as illustrated in Figure 29.

Figure 31 illustrates a top view of the damper shown in Figure 26.

Figure 32 illustrates a top view of the vanes shown in Figure 26 in a closed configuration.

Figure 33 illustrates another vane formed in accordance with an embodiment.

Figure 34 illustrates a top view of the vane shown in Figure 34.

Figure 35 illustrates a method of installing a damper in accordance with an embodiment.

### DETAILED DESCRIPTION OF PREFERRED EMBODIMENTS

The foregoing summary, as well as the following detailed description of certain embodiments will be better understood when read in conjunction with the appended drawings. To the extent that the figures illustrate diagrams of the functional blocks of various embodiments, the functional blocks are not necessarily indicative of the division between hardware circuitry. Thus, for example, one or more of the functional blocks (e.g., processors or memories) may be implemented in a single piece of hardware (e.g., a general purpose signal processor or random access memory, hard disk, or the like) or multiple pieces of hardware. Similarly, the programs may be stand alone programs, may be incorporated as subroutines in an operating system, may be functions in an installed software package, and the like. It should be understood that the various embodiments are not limited to the arrangements and instrumentality shown in the drawings.

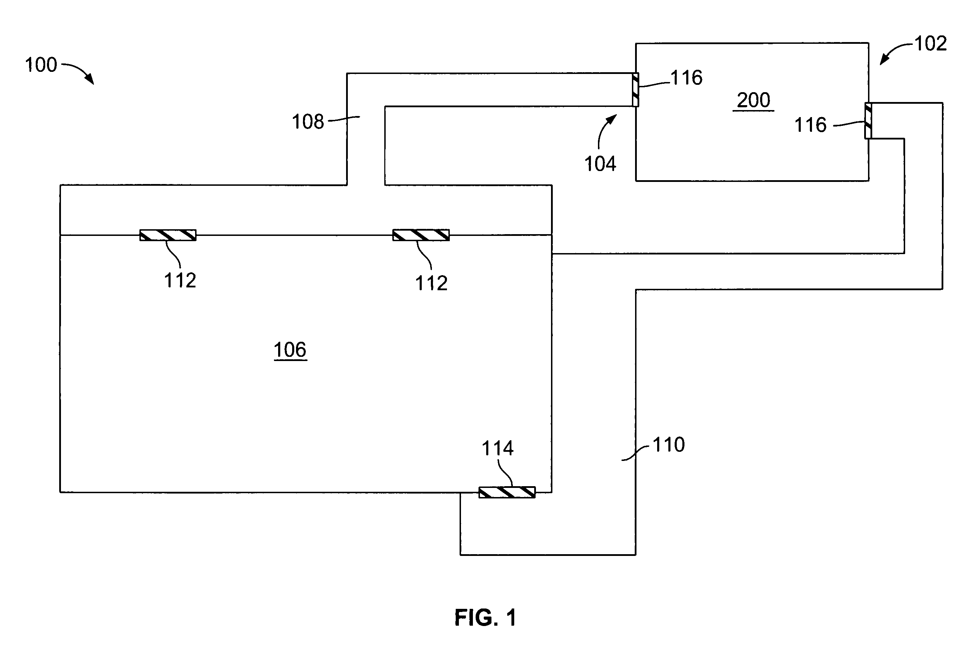

Figure 1 illustrates an air handling unit 100. The air handling unit 100 includes an air processing system 200 having an inlet 102 and an outlet 104. The air handling unit 100 is configured to condition air flowing through a room 106. The room 106 includes an inlet plenum 108 and an outlet plenum 110. The inlet plenum 108 extends between the room 106 and the outlet 104 of the air handling unit 100. The outlet plenum 110 extends from the room 106 to the inlet 102 of the air handling unit 100. Vents 112 are positioned at the junction of the inlet plenum 108 and the room 106. A return vent 114 is positioned at the junction of the outlet plenum 110 and the room 106. Optionally, filters may be positioned at each junction. The inlet plenum 108 and the outlet plenum 110 may include dampers and/or filter banks positioned therein.

At least one damper 116 is positioned within the air handling unit 100. The damper 116 controls the air flow through the air handling unit 100. Figure 1 illustrates a damper 116 positioned at the outlet 104 and the inlet 102. Optionally, the damper 116 may be positioned at only one of the outlet 104 and the inlet 102.

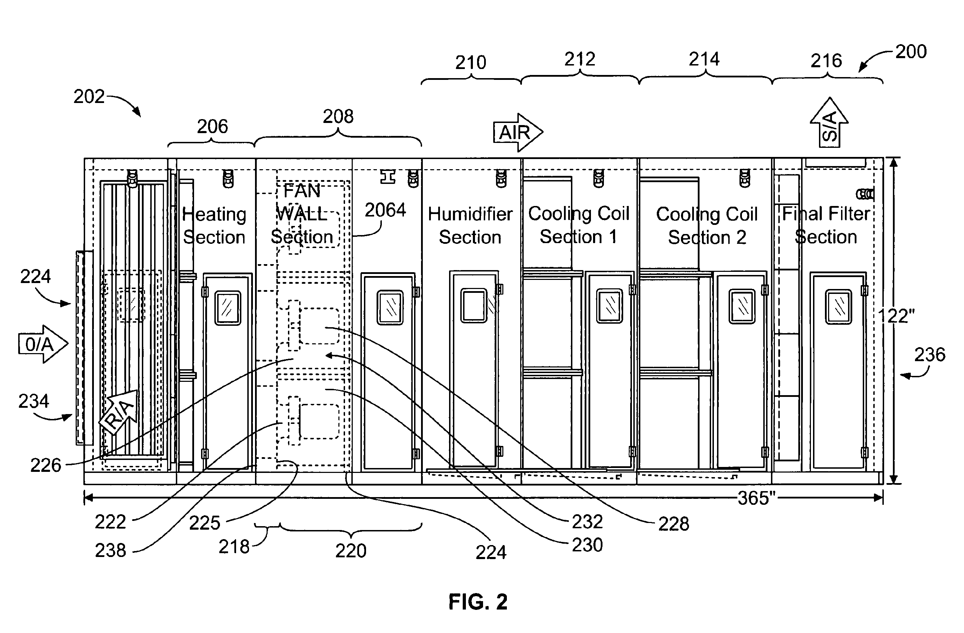

Figure 2 illustrates an air processing system 200 that utilizes a fan array air handling system in accordance with an embodiment. The system 200 includes an inlet 202 that receives air. A heating section 206 that heats the air is included and followed by an air handling section 208. A humidifier section 210 is located downstream of the air handling section 208. The humidifier section 210 adds and/or removes moisture from the air. Cooling coil sections 212 and 214 are located downstream of the humidifier section 210 to cool the air. A filter section 216 is located downstream of the cooling coil section 214 to filter the air. The sections may be reordered or removed. Additional sections may be included.

The air handling section 208 includes an inlet plenum 218 and a discharge plenum 220 that are separated from one another by a bulkhead wall 225 which forms part of a frame 224. Fan inlet cones 222 are located proximate to the bulkhead 225 of the frame 224 of the air handling section 208. The fan inlet cones 222 may be mounted to the bulkhead wall 225. Alternatively, the frame 224 may support the fan inlet cones 222 in a suspended location proximate to, or separated from, the bulkhead wall 225. Fans 226 are mounted to drive shafts on individual corresponding motors 228. The motors are mounted on mounting blocks to the frame 224. Each fan 226 and the corresponding motor 228 form one of the individual fan units 232 that may be held in separate chambers 230. The chambers 230 are shown vertically stacked upon one another in a column. Optionally, more or fewer chambers 230 may be provided in each column. One or more columns of chambers 230 may be provided adjacent one another in a single air handling section 208. The air processing system 200 may include a damper positioned at the inlet plenum 218 and/or the discharge plenum 220. Optionally, a damper may be positioned within any of the heating section 206, the air handling section 208, the humidifier section 210, the cooling coil sections 212 and 214, and the filter section 216.

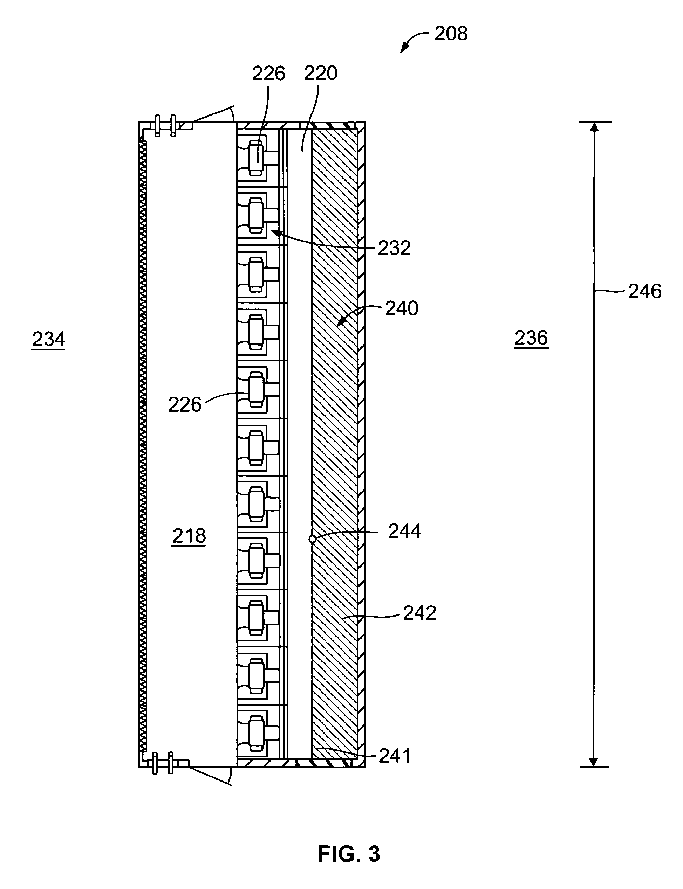

Figure 3 illustrates a top view of the air handling section 208 shown in Figure 1. The air handling section 208 includes an upstream end 234 and a downstream end 236. Fans 226 are positioned between the inlet plenum 218 and the discharge plenum 220. The inlet plenum 218 is upstream of the fans 226. The discharge plenum 220 is downstream of the fans 226. A damper 240 is positioned downstream of the fans 226. Optionally, the damper 240 may be positioned upstream of the fans 226. The damper 240 includes a frame 241 and a plurality of vanes 242 coupled to the frame. The vanes 242 rotate about separate corresponding axes 244 to control the flow of air through the air handling section 208. The vanes 242 may rotate in unison or the vanes 242 may rotate independently so that each vane is angled independently with respect to the frame 241. The damper 240 spans an entire length 246 of the air handling section 208. Optionally, the damper 240 may extend only partially along the length 246 of the air handling section. In one embodiment, the air handling section 208 may include a plenum to direct airflow to the damper 240.

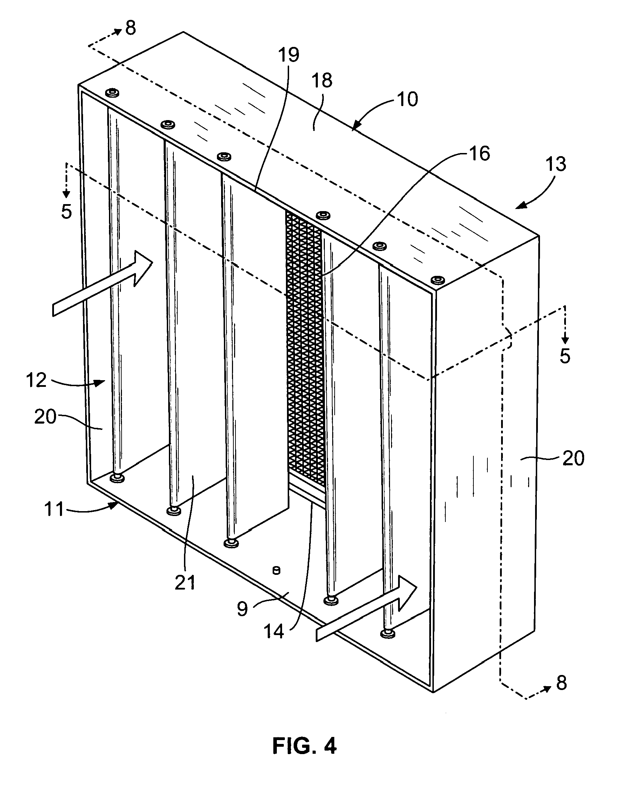

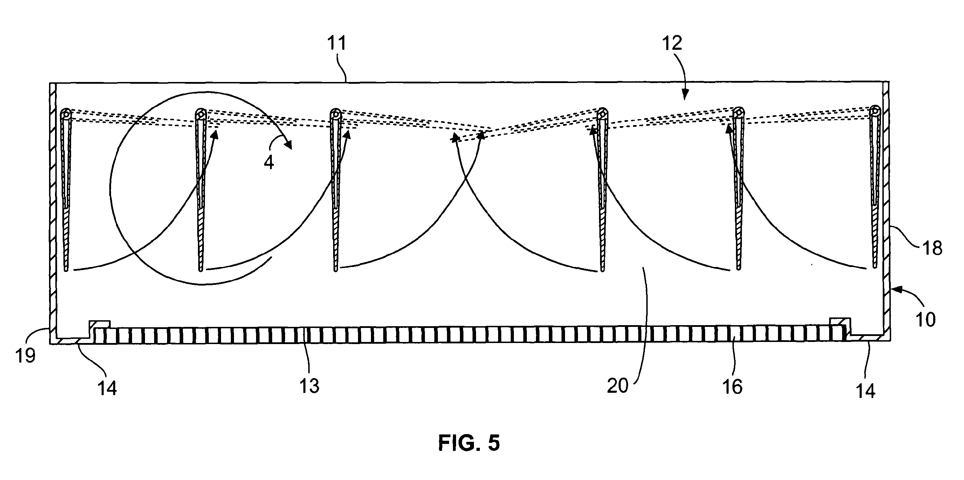

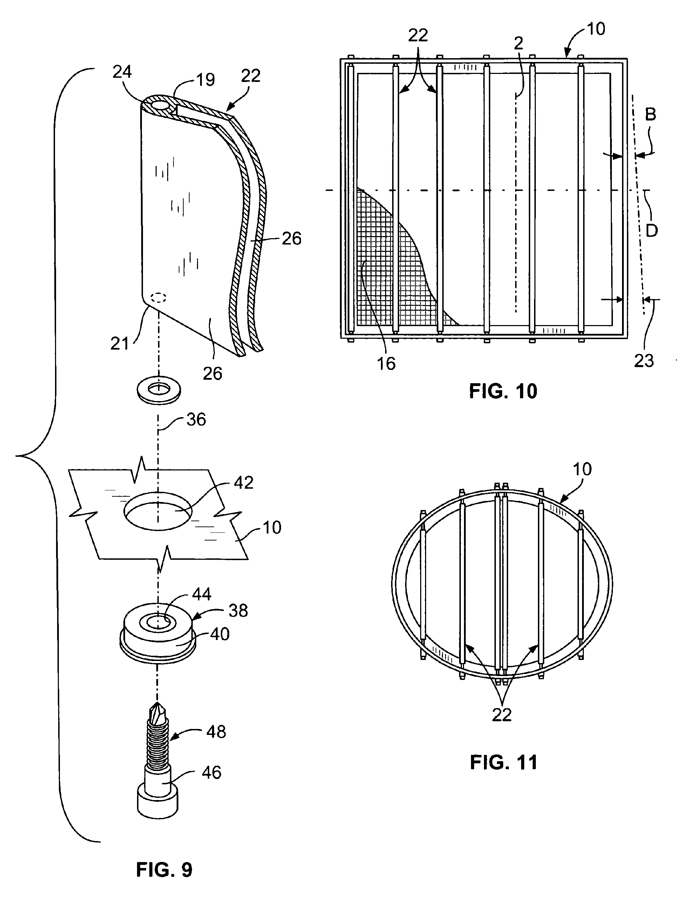

Figure 4 illustrates a damper 5 formed in accordance with an embodiment. The damper 5 has a frame 10 which defines a central opening 12. The central opening 12 has an inlet 11 and an outlet 13 through which air passes. The frame 10 may be constructed to fit into a duct or passageway (not shown) through which air flows. The frame 10 may be placed immediately upstream or downstream of a fan unit (not shown). The size of the frame 10 depends upon the size of the duct, passageway or fan unit. In various embodiments, the frame 10 may be 27" x 27" and have a depth of 8". The frame 10 is constructed of 16 gauge sheet metal and has a lip 14 located at its outlet 13 which engages an optional egg crate flow straightener 16. The frame 10 has a top 18, bottom 9 and sides 20. The frame 10 can be rectangular, as shown in Figures 4 and 5, elliptical, as shown in Figure 11, round, square, triangular, trapezoidal, or any other shape. The frame 10 can be fabricated from many types of materials and have different dimensions based on the particular application.

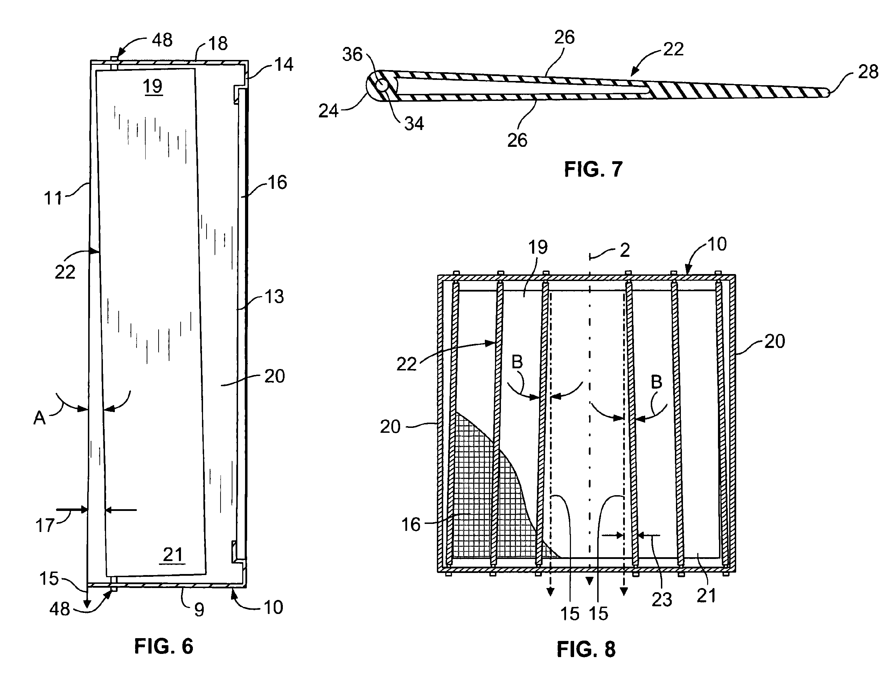

A plurality of vanes 22 extend between the top and bottom surfaces, 18, 9 of the frame 10. The vanes 22 move between open positions, as shown in Figure 4 and in the solid line in Figure 5, where air can flow substantially unimpeded through the central opening 12, and closed positions, as shown in the dashed line in Figure 5 and in Figure 8, where air cannot flow through the central opening. Referring to Figures 4 and 7, the vanes 22 have top ends 19 and bottom ends 21, rounded leading edges 24 and sides 26 which converge to thinner trailing edges 28 resulting in a neutral aerodynamic shape which creates little drag due to air flowing over the vanes 22. In various embodiments, the vanes 22 have a width which is less than or equal to the depth of the frame 10 and a length which is slightly less than the height of the frame 10. With the 27 x 27 x 8 inch frame described above the vanes 22 have a length of approximately 26'/2 inches and a width of between 6 and 8 inches, and have a thickness of between 0.250 and 0.400 inches at their leading edge 24 and between 0.050 and 0.100 inches at their trailing edge 28. In an embodiment, the blades have a thickness of 0.320 inches at the leading edge 24 and 0.086 inches at the trailing edge 28. The vanes 22 may be formed from an aluminum extrusion and are hollow to reduce their weight. The vanes 22 may weigh approximately 2 pounds each.

Cylindrical openings 24 extend through the vanes 22 at the leading edge 24, the center line of which acts as the axes 36 that the vanes 22 rotate about. The axes 36 are located proximate to the inlet 11. Optionally, the axes 36 may be positioned proximate the outlet 13 or at any location between inlet 11 and outlet 13. Additionally, the axes 36 of each vane 22 may be offset from one another. The top and bottom portions of the openings 34 are threaded. In Figures 6 and 8, the vanes 22 are rotatably mounted in the frame 10 such that their axes of rotation 36 are slightly offset 17 longitudinally at an angle A with respect to a vertical axis 15 of the frame 10. The vertical axis 15 extends in a direction of gravitational pull. In an embodiment, the tops 19 of the vanes 22 are closer to the inlet 11 than the bottoms 21 of the vanes 22. Optionally, the bottoms 21 of the vanes 22 may be closer to the inlet 11 than the tops 19 of the vanes 22. The amount of offset 17 depends on the size and weight of the vanes 22 and the amount of airflow that will pass through the damper 5. Optionally, the vanes 22 may also be offset 23 laterally with respect to the vertical axis 15. In an embodiment, the top 19 of the vanes 22 are closer to a side 20 of the frame 10 than a bottom 21 of the vanes 22. Optionally, the bottom 21 of the vanes 22 may be closer to the side 20 of the frame 10 than the top 19 of the vanes 22. In an embodiment, the vanes may be both longitudinally and laterally offset 17, 23. Additionally, each individual vane 22 may have a different offset than the other vanes 22. For example, one vane 22 may have a longitudinal offset 17 and another vane 22 may have a lateral offset 23. Additionally, the offset 17, 23 of one vane 22 may be greater than an offset 17, 23 of another vane 22.

The angle A (Figure 6) of the longitudinal offset 17 is measured along the direction of airflow from the upstream end at inlet 11 toward the downstream end at outlet 13. The purpose of the offset 17 is to cause gravity to rotate the vanes 22 to the fully closed position when there is no positive airflow through the damper 5. The offset 17 may be limited so that the vanes 22 can rotate to the open position quickly when there is a positive airflow through the frame 10. The vanes 22 become fully opened with very little airflow. In an embodiment, the offset 17 may be within a range of .5 degrees to 46 degrees.

The axes 36 of the vanes 22 can also be offset at an angle B from side-to-side with the tops 19 of the vanes 22 being closer to the vertical center line L of the frame 10 than the bottoms 21 of the vanes 22, as shown Figure 8. The angle B (Figure 8) of the lateral offset 23 is measured in a direction transverse or perpendicular to the direction of airflow. The lateral offset 23 extends along a plane of the inlet 11. The purpose of the lateral offset 23 of angle B is to cause gravity to rotate the vanes 22 to the fully closed position when there is no positive airflow through the damper 5. The offset 23 may be limited so that the vanes 22 can rotate to their open positions quickly when there is a positive airflow through the frame 10. The vanes 22 become fully opened with very little airflow. In an embodiment the offset 23 is within a range of .5 degrees to 46 degrees.

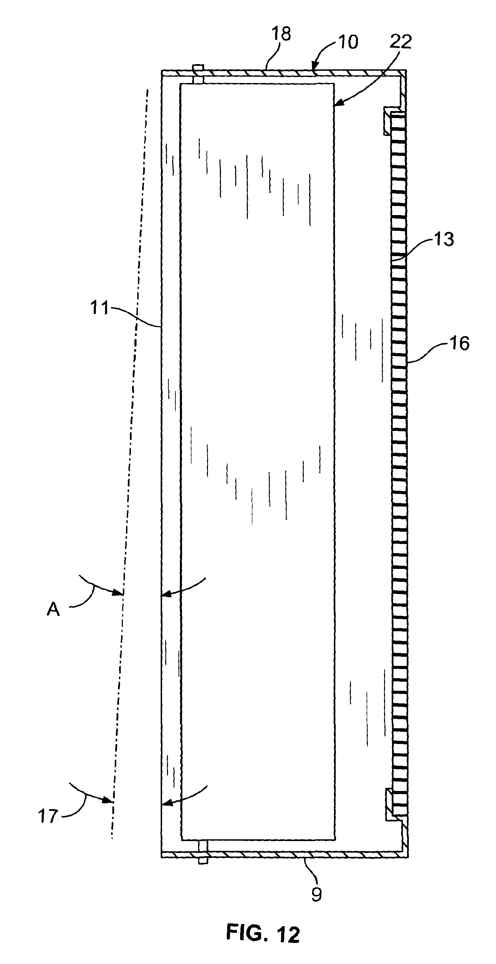

In Figures 10 and 12, the frame 10 has a vertical center line L and a horizontal center line D and rather than offsetting the axes 36 of the vanes 22 relative to the frame 10, the vertical center line L of the frame 10 is offset from the vertical by angle A to create the offset 17 of the axes 36 front to back, as shown in Figure 12. The horizontal center line D of the frame also may be offset from the horizontal by angle B to create the offset 23 of the axes 36 from side to side, as shown in Figure 10. As shown in Figure 9, the vanes 22 rotate in the frame 10 on bearings 38. The outer race 40 of each bearing is press fit into an opening 42 in the frame 10 and the inner race 44 is positioned on the shoulder 46 of a bolt 48 which fits into the circular opening in the vane 22. A bearing 38 is located at the top 19 and bottom 21 of each vane 22. The bearing 38 may be a ball bearing but other types of bearing and rotating techniques can be utilized.

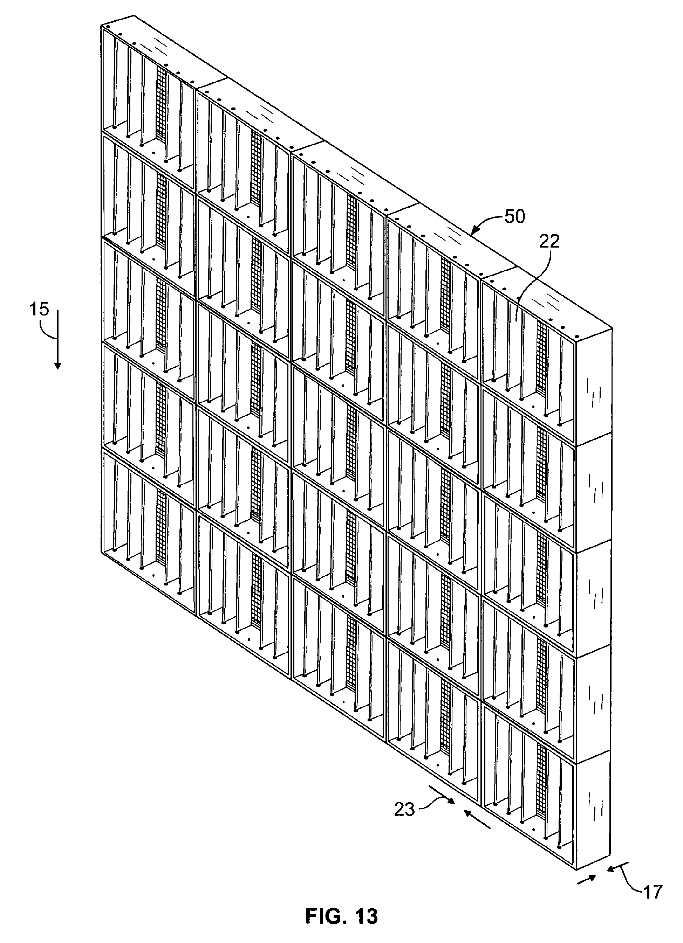

Figure 13 illustrates a plurality of the dampers 10 incorporated into a single frame 50. Each damper 10 includes vanes 22 that are offset 23, 17 with respect to the vertical axis 15. The vanes 22 may each be substantially identically offset. Optionally, the vanes 22 may be individually offset.

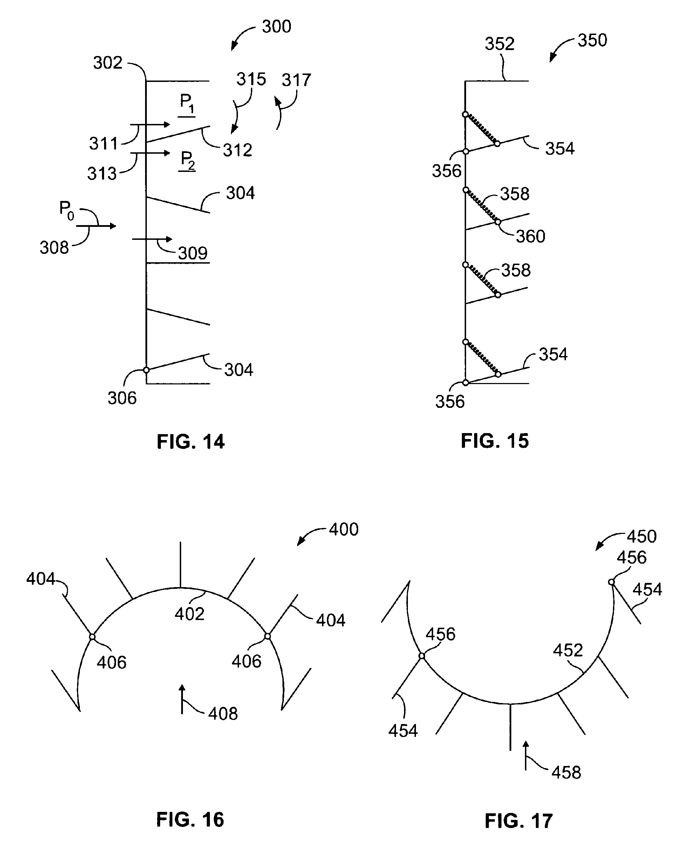

Figure 14 illustrates a top view of a damper 300 in accordance with an alternative embodiment. The damper 300 includes a frame 302 and a plurality of vanes 304. Each of the vanes 304 is pivotally coupled to the frame 302 at an axis of rotation 306. The vanes 304 maybe longitudinally and/or laterally offset with respect to a vertical axis of the frame 302. The vertical axis extends in a direction of gravitational pull. The vanes 304 are illustrated as being linearly arranged. Optionally, the vanes 304 may be offset from one another. The vanes 304 are configured to independently rotate about the respective axis of rotation 306. Airflow 308 that approaches the damper 300 generally has a pressure P₀. The airflow 308 may be uniform or non-uniform. As the airflow 308 channels through the damper 300, the airflow 308 is distributed along the vanes 304.

The airflow 308 is directed into separate channels 309 defined adjacent the vanes 304. Each channel 309 has an associated local pressure which can differ from one channel 309 to another. For example, channel 311 has a pressure P₁ and channel 313 has a pressure P₂. Air in the regions adjacent each side of the vane 304 represents a local slip stream having a pressure equal to P₁ or P₂. As either pressure P₁ or P₂ increases or decreases, the vane 304 rotates according to the change in the local slip stream pressure. For example, if the pressure P₁ increases, the vane 312 will rotate in the direction 315. If the pressure P₁ decreases, the vane 312 will rotate in the direction 317. If the pressure P₂ increases, the vane 312 will rotate in the direction 317. If the pressure P₂ decreases, the vane 312 will rotate in the direction 315. If the pressures P₁ and P₂ are approximately equal, the vane 312 will rotate to a position substantially perpendicular to an inlet of the frame 302.

Figure 15 illustrates a top view of a damper 350 in accordance with an embodiment. The damper 350 includes a frame 352 and a plurality of vanes 354. Vanes 354 are pivotally coupled to frame 352 at an axis of rotation 356. The vanes 354 may be linearly arranged or offset from one another. The vanes 354 maybe longitudinally and/or laterally offset with respect to a vertical axis of the frame 352. The vertical axis extends in a direction of gravitational pull. Each vane 354 is configured to rotate individually about the respective axis 356. A biasing mechanism 358 is coupled between each vane 354 and the frame 352. The biasing mechanism may be a spring and/or any other equivalent biasing mechanism. In the exemplary embodiment, the biasing mechanism 358 is coupled at approximately a center 360 of the vane 354. Optionally, the biasing mechanism may be coupled to any location along a length of the vane 354. Additionally, the coupling location of the biasing mechanism 358 may vary with respect to each individual vane 354. During operation airflow through the damper 350 rotates each vane 354 along the respective axis 356. The biasing mechanism 358 offsets at least a portion of the vane weight. The vane 354 is biased into an open position so that the vane 354 does not close with respect to the frame 352 thereby restricting airflow through the damper 350.

Figure 16 illustrates a top view of a damper 400 in accordance with an embodiment. The damper 400 includes a frame 402 and a plurality of vanes 404. The vanes 404 are pivotally coupled to the frame 402 along an axis of rotation 406. The vanes 404 maybe longitudinally and/or laterally offset with respect to a vertical axis of the frame 402. The vertical axis extends in a direction of gravitational pull. The vanes 404 are arranged along the arc of the frame 402. Optionally, the vanes 404 may be offset from one another. Each vane 404 is configured to rotate independently with respect to the frame 402. The frame 402 is concave with respect to a direction of airflow 408. Optionally, the frame 402 may be oriented in a convex or non-uniformly round configuration. Optionally, the configuration of the frame 402 may be V-shaped or zigzagged shaped having a plurality of angled planar sections. A non-uniform airflow 408 through the damper 400 rotates the vanes 404 independently according to the local slipstream in the region around each individual vane 404.

Figure 17 illustrates a top view of a damper 450 in accordance with an embodiment. The damper 450 includes a frame 452 and a plurality of vanes 454. The vanes 454 are coupled to the frame 452 along an axis of rotation 456. The vanes 454 are arranged along the arc of the frame 402. Optionally, the vanes 454 may be offset from one another. The vanes 454 maybe longitudinally and/or laterally offset with respect to a vertical axis of the frame 452. The vertical axis extends in a direction of gravitational pull. Each vane 454 is configured to rotate independently with respect to the frame 452. The frame 452 is convex with respect to a direction of airflow 458. Optionally, the frame 452 may be oriented in a concave or non-uniformly round configuration. Optionally, the configuration of the frame 452 may be V-shaped or zigzagged shaped having a plurality of angled planar sections. A non-uniform airflow 458 through the damper 450 rotates the vanes 454 independently according to the local slipstream in the region around each individual vane 454.

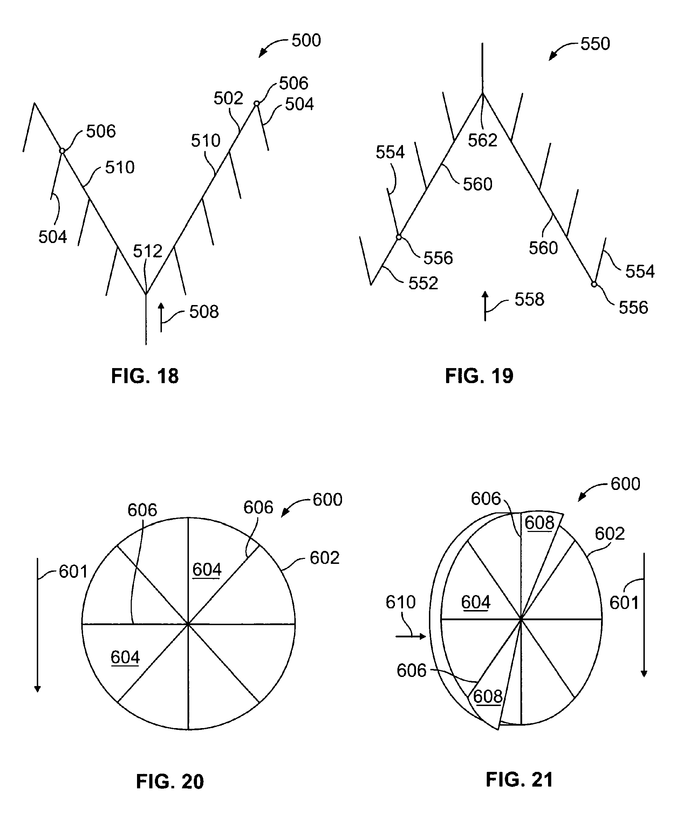

Figure 18 illustrates a top view of a damper 500 in accordance with an embodiment. The damper 500 includes a frame 502 and a plurality of vanes 504. The vanes 504 are coupled to the frame 502 along an axis of rotation 506. The vanes 504 may be linearly arranged of may be offset from one another. The vanes 504 maybe longitudinally and/or laterally offset with respect to a vertical axis of the frame 502. The vertical axis extends in a direction of gravitational pull. Each vane 504 is configured to rotate independently with respect to the frame 502. The frame 502 is V-shaped having a pair of planar sections 510. Optionally, sections 510 may be rounded. The planar sections 510 are coupled at a junction 512. The junction 512 is positioned upstream with respect to a direction of airflow 508. The junction 512 is substantially pointed. Optionally, the junction 512 may be rounded. The frame 502 includes two planar sections 510 having the same length. Optionally, the planar sections 510 may have differing lengths. In various embodiments, the frame 502 may have any number of sections 510 having any length and angular orientation. A non-uniform airflow 508 through the damper 500 rotates the vanes 504 independently according to the local slipstream in the region around each individual vane 504.

Figure 19 illustrates a top view of a damper 550 in accordance with an embodiment. The damper 550 includes a frame 552 and a plurality of vanes 554. The vanes 554 are coupled to the frame 552 along an axis of rotation 556. The vanes 554 may be linearly arranged of may be offset from one another. The vanes 554 maybe longitudinally and/or laterally offset with respect to a vertical axis of the frame 552. The vertical axis extends in a direction of gravitational pull. Each vane 554 is configured to rotate independently with respect to the frame 552. The frame 552 is V-shaped having a pair of planar sections 560. Optionally, sections 560 may be rounded. The planar sections 560 are coupled at a junction 562. The junction 562 is positioned upstream with respect to a direction of airflow 558. The junction 562 is substantially pointed. Optionally, the junction 562 may be rounded. The frame 552 includes two planar sections 560 having the same length. Optionally, the planar sections 560 may have differing lengths. In various embodiments, the frame 552 may have any number of sections 560 having any length and angular orientation. A non-uniform airflow 558 through the damper 550 rotates the vanes 554 independently according to the local slipstream in the region around each individual vane 554.

Figure 20 illustrates a damper 600 in accordance with an embodiment. The damper 600 includes a frame 602 and a plurality of vanes 604. The vanes 604 are coupled to the frame 602 along an axis of rotation 606. The vanes 604 maybe longitudinally and/or laterally offset with respect to a vertical axis 601 of the frame 602. The vertical axis 601 extends in a direction of gravitational pull. Figure 20 illustrates each of the vanes 604 in a closed configuration. The frame 602 is circular. Optionally, the frame may be oval, rectangular, non-uniformly shaped, or any other suitable geometric shape. Each vane 604 is configured as an equal pie shaped portion of the circle. Optionally, the individual vanes may have varying shapes that cumulatively equal the shape of the frame 602. The vanes 604 rotate about the respective axis 606 to open as air flows through the damper 600. Each vane is configured to rotate individually. As air flows through the damper 600, any individual vane 604 may open to an angle that corresponds to a local slipstream at the region of the vane 604. Some vanes 604 may remain closed as the air flows through. Optionally, the vanes 604 may open in unison as the air flows through the damper 600.

Figure 21 illustrates the damper 600 having vanes 608 in an open configuration. The vanes 608 are opened in response to airflow 610 through the damper 600. The vanes 608 are rotated to an angle that corresponds to a local slipstream at the region of each vane 608. The other vanes 604 are illustrated in a closed position in response to a lack of airflow therethrough. Optionally, airflow 610 may cause each vane 604 to open in response to a local slipstream.

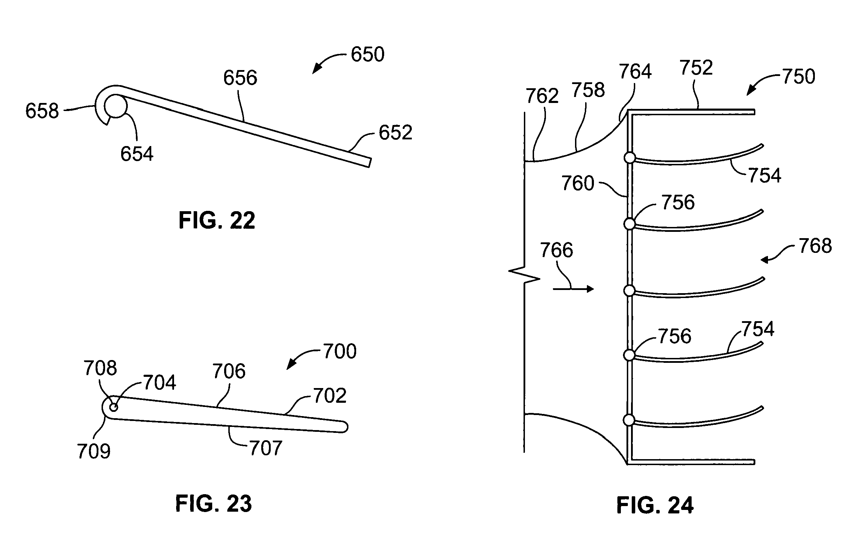

Figure 22 illustrates a damper vane 650 in accordance with an embodiment. The vane 650 includes a blade 652 and an axis member 654. The axis member 654 is configured to couple to a damper frame (not shown). The blade 652 rotates about the axis member 654. The blade includes a planar face 656. Optionally, the blade 652 may be curved, angled, or have a non-uniformly rounded shape. The blade 652 includes first end 658 that wraps around and couples to the axis 654. The blade 652 may be mechanically attached to, welded to, or integrally formed with the axis 654. The blade 652 may be hollow, solid, or have a honeycomb configuration. Optionally, the blade 652 may include filtering layers and/or sound attenuating layers. The blade 652 may be fabricated through extrusion, stamping, forming, or molding. Additionally, the blade 652 may be fabricated from metal, polymers, or threaded cotton.

Figure 23 illustrates a damper vane 700 in accordance with various embodiments. The vane 700 includes a blade 702 and an axis member 704. The axis member 704 is configured to couple to a damper frame (not shown). The blade 702 rotates about the axis member 704. The blade includes a pair of planar faces 706 and 707. Optionally, the planar faces 706 and 707 may be curved, angled, or have a non-uniformly rounded shape. The blade 702 includes first end 708 extending from the first planar face 706 and a second end 709 that extends from the second planar face 707. The first end 708 wraps around and couples to the axis member 704. The first end 708 may be mechanically attached to, welded to, or integrally formed with the axis 704. The second end 709 wraps around and couples to the first end 708. The second end 709 may be mechanically attached to, welded to, or integrally formed with the first end 708. The blade 702 may be hollow, solid, or have a honeycomb configuration. Optionally, the blade 702 may include filtering layers and/or sound attenuating layers. The blade 702 may be fabricated through extrusion, stamping, forming, or molding. Additionally, the blade 702 may be fabricated from metal, polymers, or threaded cotton.

Figure 24 illustrates a top view of a damper 750 in accordance with an embodiment. The damper 750 includes a frame 752 and a plurality of vanes 754. The vanes 754 are coupled to the frame 752 at an axis of rotation 756. The vanes 754 may be linearly arranged or may be offset from one another. The vanes 754 maybe longitudinally and/or laterally offset with respect to a vertical axis of the frame 752. The vertical axis extends in a direction of gravitational pull. The vanes 754 are configured to rotate independently about the respective axis 756. The vanes 754 are curved. Optionally, the vanes 754 may be angled, planar, non-uniformly round, or any combination thereof.

A shroud 758 is coupled to the frame 752. The shroud 758 is coupled to an inlet 760 of the frame 752. The shroud 758 is rounded and has an inlet 762 having a smaller diameter than an outlet 764 of the shroud 758. The shroud expends airflow 766 as the air enters the damper 750. Optionally, the inlet 762 has a diameter that is greater than the outlet 764 and the shroud condenses the air flow 766 as it enters the damper 750. Additionally, the shroud 758 may have planar angled sides. The shroud 758 may also be positioned at an outlet 768 of the damper 750 to either condense or expand the airflow 766 as it exits the damper 750.

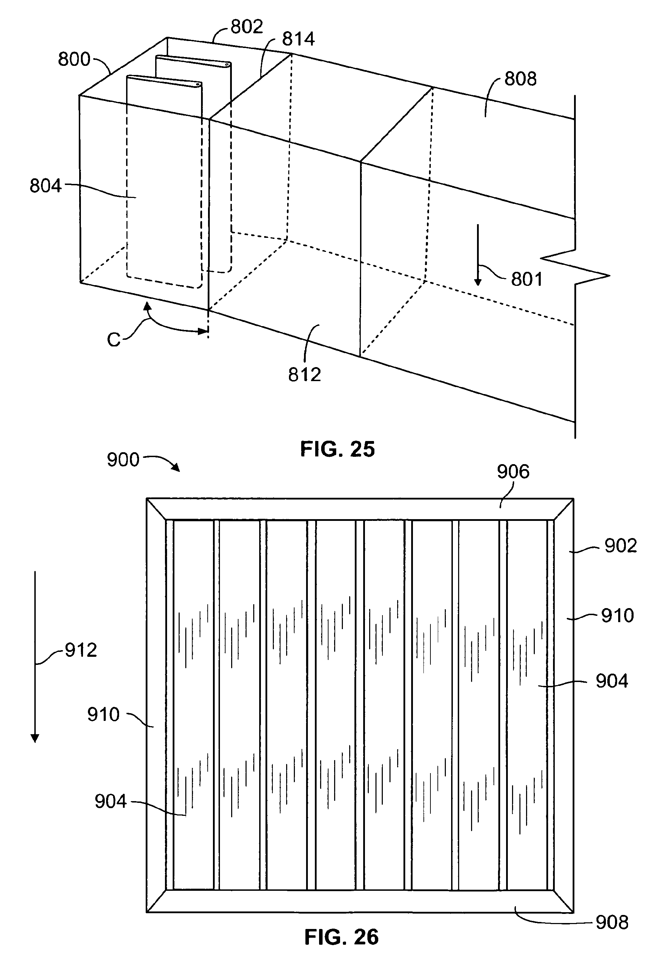

Figure 25 illustrates a damper 800 in accordance with an embodiment. The damper 800 includes a frame 802 and a plurality of vanes 804. The vanes 804 are coupled to the frame 802 at an axis of rotation 806. The vanes 804 may be linearly arranged of may be offset from one another. The frame 802 is positioned within a plenum 808. A vertical axis 801 extends through the plenum 808 in a direction of gravitational pull. The frame 802 is offset 810 at an offset angle C that is non-orthogonal to the vertical axis 801. The frame 802 may be pitched and/or rolled with respect to the vertical axis 801. The offset angle C of the frame causes the vanes 804 to also be offset from the vertical axis 801. In an embodiment, the damper 800 is coupled to a standoff 812. The standoff 812 has a coupling surface 814 that is non-orthogonal to the vertical axis 801 and includes offset 810. The damper 800 is coupled to the standoff to offset the damper 800 by offset 810.

The purpose of the offset 810 is to cause gravity to rotate the vanes 804 to the fully closed position when there is no positive airflow through the damper 800. The offset 810 may be limited so that the vanes 804 can rotate to the open position quickly when there is a positive airflow through the frame 802. The vanes 804 become fully opened with very little airflow. In an embodiment, the offset 810 may be within a range of .5 degrees to 46 degrees.

Figure 26 illustrates a damper 900 in accordance with an embodiment. The damper 900 includes a frame 902 and a plurality of vanes 904. The frame 902 includes a top 906, a bottom 908, and a pair of sides 910. The vanes 904 extend between the top 906 and the bottom 908 of the frame 902. The frame 902 includes a vertical axis 912 that extends in a direction of gravitation pull. The vanes 904 are configured to rotate about an axis of rotation. The axis of rotation may extend along the vertical axis 912 of the frame 902. Alternatively, the axis of rotation may be laterally and/or longitudinally offset from the vertical axis 912 of the frame 902. Optionally, the frame 902 may be positioned within a plenum having a vertical axis that extends in a direction of gravitational pull. The frame 902 may be laterally and/or longitudinally offset from the vertical axis of the plenum. The vanes 904 are configured to rotate about the axis of rotation between an open position and a closed position. In the open position, air is allowed to flow through the damper 900. In the closed position, air does not flow through the damper 900. The vanes 904 are configured to seal the damper 900 when in the closed position.

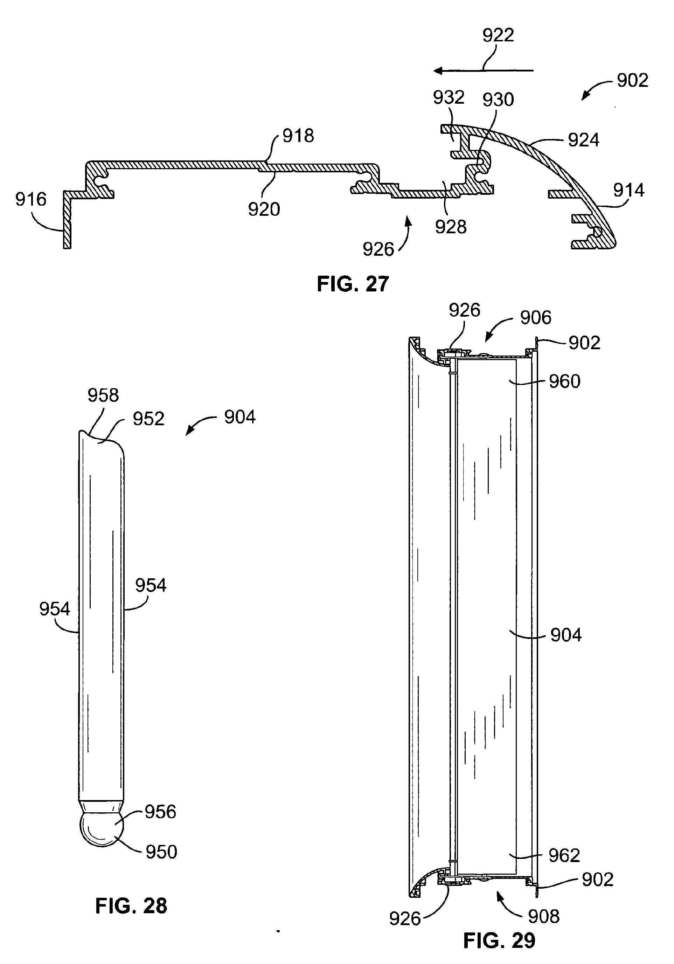

Figure 27 illustrates a cross-sectional view of the frame 902. The frame 902 includes a front face 914 and a rear face 916. The frame 902 also includes an inner face 918 and an outer face 920 extending between the front face 914 and the rear face 916. Air flows in the direction of arrow 922 along the inner face 918 from the front face 914 to the rear face 916. The front face 914 has an arcuate member 924 that directs the airflow through the damper 900. Downstream from the arcuate member 924, the frame 902 includes a coupling mechanism 926. The coupling mechanism 926 is configured to retain the vanes 904 within the frame 902. The coupling mechanism 926 includes a ball bearing cutout 928 for receiving a ball bearing (described below). The ball bearing enables the vane 904 to rotate with respect to the frame 902. A bearing plate notch 930 is positioned adjacent the ball bearing cutout 928. The bearing plate notch 930 retains a bearing plate (described below) configured to retain the vane 904 within the frame 902. The coupling mechanism 926 also includes a gasket notch 932 for retaining a gasket (described below). The gasket creates a low pressure seal between the vane 904 and the frame 902.

Figure 28 illustrates a top view of the vane 904 shown in Figure 26. The vane 904 includes a leading edge 950 and a trailing edge 952. Planar faces 954 extend between the leading edge 950 and the trailing edge 952. The leading edge 950 includes a rotational member 956. The rotational member 956 couples to the frame 902 along the axis of rotation of the vane 904. In the example embodiment, the rotational member 956 is rounded. Optionally, the rotational member 956 may have any shape suitable for rotating the vane 904. The trailing edge 952 includes a cutout 958. The cutout 958 is rounded to nest flush with a rounded rotational member 956 of an adjacent vane 904. In an embodiment having non-rounded rotational members 956, the cutout 958 is shaped to correspond with the shape of the rotational member 956.

Figure 29 illustrates a vane 904 coupled to the frame 902. The vane 904 includes a top 960 and a bottom 962. The top 960 is coupled to the top 906 of the frame 902. The bottom 962 is coupled to the bottom 908 of the frame 902. The top 960 and the bottom 962 are each coupled to a coupling mechanism 926 of the frame 902.

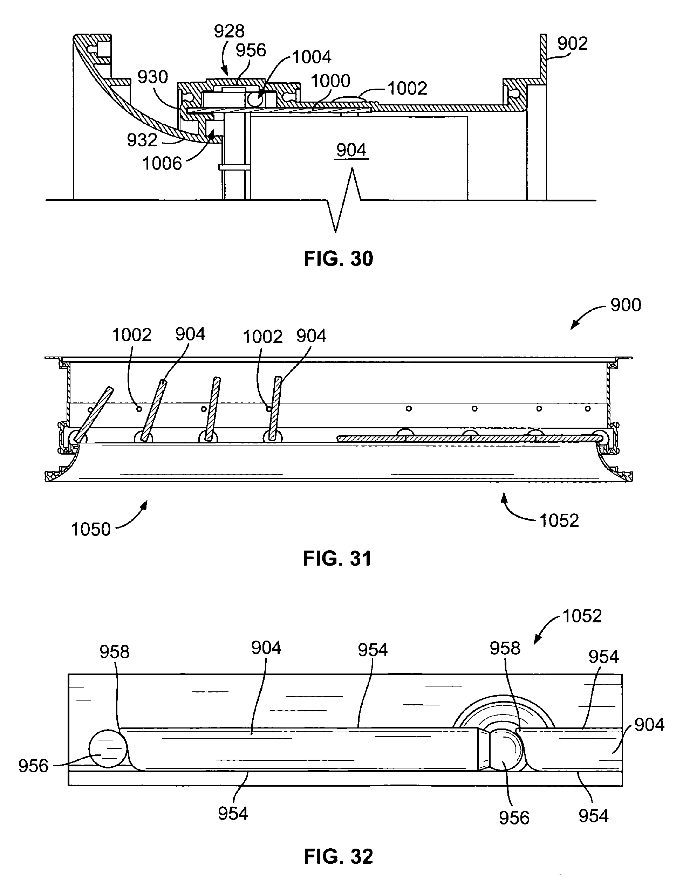

Figure 30 is an expanded view of the vane 904 coupled to the frame 902. A bearing plate 1000 is positioned within the bearing plate notch 930 of the frame 902. The bearing plate 1000 is secured to the frame 902 with a rivet 1002. The rotational member 956 of the vane 904 extends through an aperture formed in the bearing plate 1000. A ball bearing 1004 is coupled to the rotational member 956 of the vane. The ball bearing 1004 is positioned within the ball bearing cutout 928 of the frame 902. The ball bearing 1004 is retained by the bearing plate 1000. The ball bearing 1004 and the bearing plate 1000 retain the vane 904 within the frame 902. A gasket 1006 is positioned within the gasket notch 932. The gasket 1006 forms an airtight interface with the vane 904. The gasket 1006 includes a surface that enables the vane 904 to rotate with respect to the frame 902 while maintaining a sealing contact with the gasket 1006. It should be noted that the interface between the vane 904 and the frame 902 illustrated in Figure 30 is common to both the top 906 and bottom 908 of the frame 902.

Figure 31 illustrates a top view of the damper 900 shown in Figure 26. The damper 900 includes a plurality of vanes 904. The vanes 904 are configured to rotate independently based on the local slipstream adjacent the vane 904. Figure 31 illustrates half of the vanes 904 in an open configuration 1050 and half of the vanes 904 in a closed configuration 1052. In the open configuration 1050 the vanes open to an angle with respect to the frame 902 that is contingent on the local slipstream adjacent the vane 904. The rivets 1002 extend from the frame 902 to limit the maximum angle that the vanes 904 can open. The rivet 1002 stops the rotation of the vanes 904 at an angle that is less than 90 degrees. If a back pressure is experienced in the damper 900, the vanes 904 are forced back to the closed configuration 1052. In the closed configuration 1052, the vanes 904 are positioned in a linear relationship. The closed configuration 1052 of the vanes is illustrated in Figure 32.

Figure 32 illustrates a top view of the vanes 904 in the closed configuration 1052. The cutout 958 of each vane 904 is nested flush with the rotational member 956 of an adjacent vane 904 to form a seal. The configuration of the cutout 958 and the rotational member 956 enables the vanes 904 to position in a linear configuration. The linear configuration creates planar walls 1054 formed by the planar faces 954 of each vane. The planar walls 1054 extend across the frame 902 to seal the damper 900.

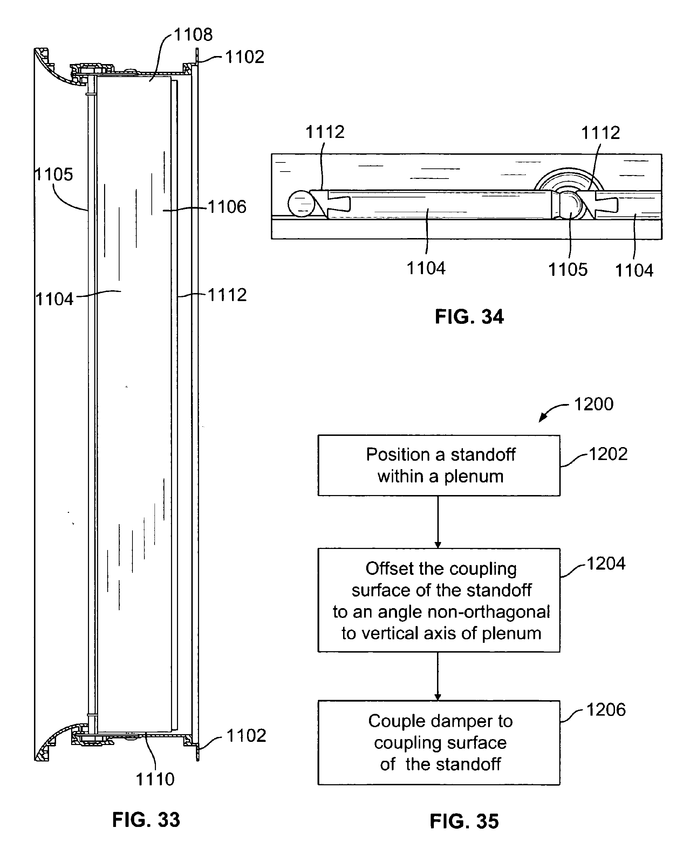

Figure 33 illustrates another vane 1104 coupled to a frame 1102. The vane 1104 includes a leading edge 1105 and a trailing edge 1106. The vane 1104 rotates about an axis of rotation that extends through the leading edge 1105. The trailing edge 1106 extends from a top 1108 to a bottom 1110 of the vane 1104. The vane 1104 includes a gasket 1112 extending from the top 1108 to the bottom 1110 along the trailing edge 1106.

Figure 34 illustrates a top view of the vane 1104 in a closed configuration 1114. In the closed configuration 1114 the gasket 1112 is nested flush against the leading edge 1105 of an adjacent vane 1104. The gasket 1112 accounts for misalignments in the vane 1104 or the frame 1102 to provide a low leak seal between adjacent vanes 1104.

A method 1200 of installing a damper is illustrated in Figure 35. The damper includes a frame and a plurality of vanes. The vanes are coupled to the frame at an axis of rotation. The vanes are configured to rotate between an open and closed position. The damper is configured to be installed in an existing plenum. The plenum has a vertical axis that extends in a direction of gravitational pull. At 1202, at standoff is positioned within the plenum. The standoff includes a coupling surface. At 1204, the coupling surface is offset with respect to the vertical axis. The coupling surface may be pitched, rolled, or yawed with respect to the vertical axis. At 1206, the damper is coupled flush with the coupling surface. The offset angle of the coupling surface offsets the damper with respect to the vertical axis. The damper is pitched, rolled, or yawed such that gravity rotates the vanes of the damper to the fully closed position when there is no positive airflow through the damper. The offset may be limited so that the vanes can rotate to the open position quickly when there is a positive airflow through the frame. The vanes become fully opened with very little airflow. In an embodiment, the offset may be within a range of .5 degrees to 46 degrees. Optionally, the damper may be coupled directly to the plenum and offset with respect to the vertical axis of the plenum.

The embodiments described herein are described with respect to an air handling system. It should be noted that the embodiments described may be used within the air handling unit and/or in the inlet or discharge plenum of the air handling system. The embodiments may also be used upstream and/or downstream of the fan array within the air handling unit. Optionally, the described embodiments may be used in a clean room environment. The embodiments may be positioned in the discharged plenum and/or the return chase of the clean room. Optionally, the embodiments may be used in residential HVAC systems. The embodiments may be used in the ducts of an HVAC system. Optionally, the embodiments may be used with precision air control systems, DX and chilled-water air handlers, data center cooling systems, process cooling systems, humidification systems, and factory engineered unit controls. Optionally, the embodiments may be used with commercial and/or residential ventilation products. The embodiments may be used in the hood and/or inlet of the ventilation product. Optionally, the embodiment may be positioned downstream of the inlet in a duct and/or at a discharge vent.

It is to be understood that the above description is intended to be illustrative, and not restrictive. For example, the above-described embodiments (and/or aspects thereof) may be used in combination with each other. In addition, many modifications may be made to adapt a particular situation or material to the teachings of the various embodiments of the invention without departing from their scope. While the dimensions and types of materials described herein are intended to define the parameters of the various embodiments of the invention, the embodiments are by no means limiting and are exemplary embodiments. Many other embodiments will be apparent to those of skill in the art upon reviewing the above description. The scope of the various embodiments of the invention should, therefore, be determined with reference to the appended claims, along with the full scope of equivalents to which such claims are entitled. In the appended claims, the terms "including" and "in which" are used as the plain-English equivalents of the respective terms "comprising" and "wherein." Moreover, in the following claims, the terms "first," "second," and "third," etc. are used merely as labels, and are not intended to impose numerical requirements on their objects. Further, the limitations of the following claims are not written in means-plus-function format and are not intended to be interpreted based on 35 U.S.C. § 112, sixth paragraph, unless and until such claim limitations expressly use the phrase "means for" followed by a statement of function void of further structure.

As used herein, an element or step recited in the singular and proceeded with the word "a" or "an" should be understood as not excluding plural of the elements or steps, unless such exclusion is explicitly stated. Furthermore, references to "one embodiment" are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

This written description uses examples to disclose the various embodiments of the invention, including the best mode, and also to enable any person skilled in the art to practice the various embodiments of the invention, including making and using any devices or systems and performing any incorporated methods. The patentable scope of the various embodiments of the invention is defined by the claims, and may include other examples that occur to those skilled in the art. Such other examples are intended to be within the scope of the claims if the examples have structural elements that do not differ from the literal language of the claims, or if the examples include equivalent structural elements with insubstantial differences from the literal languages of the claims.

## Claims

1. A damper comprising:
a frame having a central opening through which air passes; and
a plurality of vanes rotatably mounted within the frame, at least one of the vanes oriented about a rotational axis that is offset at a non-orthogonal angle with respect to one of a horizontal and vertical axis.

2. The damper of Claim 1, wherein the vertical axis extends in a direction of gravitational pull.

3. The damper of Claim 2, wherein the frame is offset at a non-orthogonal angle with respect to the vertical axis.

4. The damper of Claim 1, wherein the vanes rotate independently of each other.

5. The damper of Claim 1, wherein the frame has one of a rectilinear, elliptical, or circular cross section.

6. The damper of Claim 1 further comprising a biasing mechanism to offset a weight of each vane.

7. The damper of Claim 6, wherein the biasing mechanism is a spring.

8. The damper of Claim 1, wherein the vanes have a leading edge and a trailing edge, the rotational axis positioned proximate the leading edge.

9. The damper of Claim 1, wherein the frame has a vertical center line and the vanes pivot about rotational members, the rotational members oriented such that upper ends of the rotational member are positioned proximate to the center line and lower ends of the rotational member are positioned distally from the center line.

10. The damper of Claim 1, wherein the frame has a vertical center line and the vanes pivot about rotational members, the rotational members oriented such that upper ends of the rotational member are positioned distally from the center line and lower ends of the rotational member are positioned proximate to the center line.

11. The damper of Claim 1, wherein the frame has a depth and the vanes have a width which is not greater than the depth.

12. The damper of Claim 1, wherein the vanes are offset from the plane of the housing within a range of 0.5 degrees and 45 degrees.

13. The damper of Claim 1, wherein the vanes are offset so that the vanes rotate to a closed position when there is substantially no airflow through the frame.

14. The damper of Claim 1, wherein the vanes comprise an axis and a blade, the blade coupled to the axis by at least one of mechanical attachment or welding.

15. The damper of Claim 1, wherein the vanes are at least one of hollow, solid, or honeycombed.

16. The damper of Claim 1, wherein the frame has sides, a top, a bottom, an inlet end, and a discharge end, the inlet end defines an inlet plane and the rotational axis is oriented non-parallel to the inlet plane.

17. The damper of Claim 1, wherein the frame has sides, a top, a bottom, an inlet end, and a discharge end, the rotational axis is oriented non-parallel to the sides.

18. The damper of Claim 1 further comprising a gasket positioned between the frame and each vane to seal the vanes with respect to the frame.

19. The damper of Claim 1 further comprising a rivet to limit the rotation of the vanes.

20. The damper of Claim 1 further, wherein the vanes include a leading edge and a trailing edge, the vanes having a gasket extending along the trailing edge.

21. The damper of Claim 20, wherein the gasket nests against the leading edge of an adjacent vane when the vanes are in a closed position.

22. The damper of Claim 1 further, wherein the vanes include a leading edge and a trailing edge, the vanes having a gasket extending along the trailing edge.

23. The damper of Claim 22, wherein the gasket nests against the leading edge of an adjacent vane when the vanes are in a closed position.

24. A method of installing a damper, the damper having a frame, said method comprising:
rotatably mounting a plurality of vanes within the frame; and
orienting at least one of the vanes about a rotational axis that is offset at a non-orthogonal angle with respect to one of a horizontal and vertical axis.

25. The method of Claim 24, wherein the vertical axis extends in a direction of gravitational pull, the method further comprising offsetting the frame at a non-orthogonal angle with respect to the vertical axis.

26. The method of Claim 24, further comprising rotatably mounting the plurality of vanes so that the vanes rotate independently of each other.

27. A damper comprising:
a frame having a central opening through which air passes; and
a plurality of vanes rotatably mounted within the frame, the vanes having a leading edge and a trailing edge, the leading edge comprising a rotational member and the trailing edge comprising a cutout having a shape that corresponds with the shape of the rotational member to nest with the rotational member of an adjacent vane when the vanes are in a closed position.

28. The damper of Claim 27 further comprising a gasket positioned between the frame and each vane to seal the vanes with respect to the frame.

29. The damper of Claim 27 further comprising a rivet to limit the rotation of the vanes.

30. The damper of Claim 27, wherein at least one of the vanes is oriented about a rotational axis that is offset at a non-orthogonal angle with respect to one of a horizontal and vertical axis.
